# EUROPEAN PATENT APPLICATION

(11) **EP 2 902 779 A1**
(43) Date of publication of application: **05.08.2015**
(21) Application number: 14460013.7
(22) Date of filing: 03.03.2014
(51) Int. Cl.: G01N 27/72, G01N 27/82, G01R 33/07, G01R 33/028

(54) **System for measuring the properties of soft magnetic materials, in particular sheets and bands**

(30) Priority: 23.12.2013 PL 40663413
(71) Applicant: Instytut Elektrotechniki, 04-703 Warzawa (PL)
(72) Inventor: Gaworska-Koniarek, Dominika, 50-372 Wroclaw (PL); Bajorek, Jerzy, 53-139 Wroclaw (PL); Wilczynski, Wieslaw, 51-659 Wroclaw (PL)
(74) Representative: Kozlowska, Regina

(57) **Abstract**

The subject of this invention is a system for measuring the characteristics of soft magnetic materials, in particular sheets and tapes with arbitrary shapes, by nondestructive method.

The system contains a generator (1) connected through a block for signal conditioning (2), active filter (3) and power amplifier (4) with an input of measuring head (5) whose at least one couple of output terminals is connected through the circuit for measuring signals conditioning (6) and the circuit for data collection (7) with an analog-digital transducer (8) connected to a microprocessor (13), whereas the microprocessor (13) is connected with the screen (12) and through the control circuit of the block for measuring signals conditioning (9) with the circuit for conditioning measuring signals (6) through the control system for generator (11) with the generator (1) and also through the circuit for shunt control (10) with the shunt (18) connected between the measuring head (5) and the ground.

## Description

The subject of this invention is a system for measuring the properties of soft magnetic materials, especially sheets and tapestapes of arbitrary shape, by non-destructive method.

Electrotechnical steel sheets are the basic and strategic, soft magnetic materials applied in production of magnetic cores of electromagnetic machines and devices. The quality of magnetic core, its magnetic performance, depend strongly on the selection of electrotechnical steel sheets, the way of their machining and the structure. The values of magnetic parameters of electrotechnical steel sheets, obtained from the measurements using standardized test apparatus, e.g. Epstein's apparatus or single sheet tester (SST), are significantly different from the actual values of the parameters of magnetic cores in machines and devices. Laboratory studies do not take into account the degradation processes occurring during the sheet machining and the process of punching of an magnetic core, applied, for instance, in a rotating machine. During fabrication of a final product the magnetic cores are subjected to various technological processes such as punching, gluing, stacking, riveting, etc. This deteriorates magnetic properties of the material, and the extent of the changes depends on the way of machining, kind of sheet as well as final effective cross-section of the magnetic core.

The system for measuring properties of soft magnetic materials, specially of bulky toroidal cores, known from the Polish patent application No PL146637, has on its base radially arranged metal bars of good electrical conductivity, covered on a specified length with a slidable isolation. On the tapered side, flexible cords with adjustable length, finished with terminal blocks, are mounted on the bars with sliding contacts. The device, according to the invention, can serve for measurement of correction field, magnetic permeability, magnetic induction, magnetic remanence. The parameters can be measured both in a uniform as well as in an alternating magnetizing field at changing frequency.

The system and the method for determining spatial distributions of mechanical characteristics and/or directions and values of mechanical strain on the surface of ferromagnetic materials are known from the Polish patent application No PL176699. The method consists in that the ferromagnetic material is subjected to cyclic magnetization in a magnetic field with a changing direction up to the point when the level of Barkhausen noise appoints the magnetic field direction at which the value of a signal induced in the measuring transducer achieves its extreme values, determining the direction of easy and difficult magnetization, which are connected with the directions of major mechanical strain. Then, the magnetization direction at which the measured signal does not depend on the value of mechanical strain, but on the material structural properties only, is searched for by adjusting the value of magnetization current suitable for this direction, and after repeated measurement of Barkhausen noise, the value of major mechanical strain is determined. The system is equipped with a magnetizing winding, winding of magnetic potentiometer and winding of measuring transducer for the measuring head connected with an analyzing circuit including amplifiers, filters and a computer port connected through a pulse forming circuit. The magnetizing winding is supplied by ac and dc current sources powered from corresponding units of a tunable generator. The winding of the magnetic potentiometer is connected, through an amplifier, comparator and controller with an amplitude amplifier of magnetization current, which controls the ac current sources.

The device for testing dia- and paramagnetic properties of solid or liquid substances, known from the Polish patent application No PL297546, is characterized by that the specimen of dia- or paramagnetic substance, in a solid or liquid state, has a form of a cylinder positioned on two parallel, non-ferromagnetic, horizontal dovetail ways in heterogeneous magnetic field generated by a C-shaped magnet, advantageously iron-neodymium-boron or samarium-cobalt, equipped with removable pole shoes made of chemically pure iron, while one of them is cylindrically concave and the other one, prismatically cut. The magnet rests on a horizontal non-ferromagnetic base connected with the ways and having on the bottom four spring washers made of mocroporous rubber, and elongated gap between the ways. Specimens of liquid substance are positioned on the ways in a thin-walled pipe closed with plugs on its both ends.

The device for testing discontinuities of structure of ferromagnetic details on a restricted testing area, known from the Polish patent application No PL212769, has a yoke of ferromagnetic material in a C-shape with elongated and bent ends, which penetrates the magnetizing winding positioned at the longer part of the C-shape, while at each bent end of the yoke arm there are two holes through which two details, tested and standard, pass slidably, whereby, in the space between the bent ends of the yoke there are two measuring coils, one on the standard and the other one on the tested detail, whereas two remaining measuring coils are outside the testing area at the opposite ends of the yoke, one on the standard and the other one on the tested detail and the axes of the measuring coils are perpendicular to the axis of the magnetizing winding.

The device for testing discontinuities of the structure of ferromagnetic details, known from the Polish patent application No PL212770, consists of two independent yokes, a magnetizing coil of circular cross-section inside which ferromagnetic details are positioned, whereas inside the magnetizing coil there is a magnetic screen made of electrotechnical steel sheets in a shape of a rectangular prism with a square base or in a shape filling cross section of the magnetizing coil, with four hollows in which identical measuring coils are positioned, and in two arbitrarily selected measuring coils there are a standard and a tested detail, slidably threaded through the ends of the yokes in the shape of "U" or "C", closing the magnetic flux.

The essence of the system, according to the invention, consists in that it has a generator connected through a block for signal conditioning, active filter and power amplifier with an input of measuring head, whose at least one couple of output terminals is connected through the circuit for measuring signals conditioning and the circuit for data collection with an analog-digital transducer connected to a microprocessor, whereas the microprocessor is connected with the screen and through the control circuit of the block for measuring signals conditioning with the circuit for conditioning measuring signals, through the control system for generator with the generator and also through the circuit for shunt control with the shunt connected between the measuring head and the ground. The terminals of the shunt are connected with the circuit for conditioning measuring signals.

It is advantageous that the measuring head has at least one excitation circuit made of at least one magnetizing yoke in a shape of U, creating a magnetic core, on which at least one magnetizing coil is located, whereby in a pole of the magnetizing yoke there is at least one inductive sensor and, between the poles of the excitation circuit, there is at least one inductive sensor of magnetic field strength. Advantageously, the circuit is made of three identical yokes in a shape of U, arranged in relation to each other at a distance of less than 10.0 mm.

Advantageously, the inductive sensor is made in the form of a coil for measuring magnetic flux, with a height less than 5 mm.

Advantageously, the inductive sensor is located inside a magnetizing yoke under the surface of its pole.

Advantageously, the measuring head has two excitation circuits and each of them consists of at least one magnetizing yoke in a shape of U which makes a magnetic core, whereby the magnetic system at the bottom and the magnetic system on the top are directed toward each other with their magnetizing poles which stick to each other. The most advantageously, the windings of the magnetizing coils are connected in such manner that the magnetic flux of each pole couple of the bottom and the upper magnetic cores are directed opposite to each other.

Advantageously, the inductive sensor of magnetic field strength is magnetically coupled with vertical magnetic cores of soft magnetic materials, ensuring magnetic contact with the surface of the tested object.

Advantageously, below the lower surface of at least one pole of the magnetizing yoke there is an inductive sensor, and the most advantageously the magnetizing coils encompass the inductive sensor. Furthermore, the inductive sensor of magnetic field strength is coupled magnetically with vertical shields made of a soft magnetic material.

The system for measuring the characteristics of magnetic soft materials has a simple structure, is functional and universal since the application of appropriately selected measuring head makes possible to control the quality of impressions made of magnetic materials without the necessity of individual preparation specimens from this material before every test. The system enables quality control of impressions from electrotechnical steel sheets at every stage of production process of electrical machines and electromagnetic devices using non-destructive methods. The measurement principle and the design of the head are based on the continuity of tangential component of magnetic field at the ferromagnetic material- air interface and the continuity of magnetic flux at the magnetizing circuit - tested object boundary. The system may be successfully used also for openwork punched parts from electrotechnical steel sheets, which is especially important in testing of irregular openwork magnetic cores of electrochemical steel sheets, e.g. the packet of an electric motor stator. In the measuring system, uniform magnetic field distribution is used only in a limited testing area which causes that the measurement result is independent of geometry and configuration of testing system of magnetization circuit and the tested object. Furthermore, in the measurement of local magnetic characteristics of a tested object, in case of loss measurement, only the knowledge of density of tested materials is required.

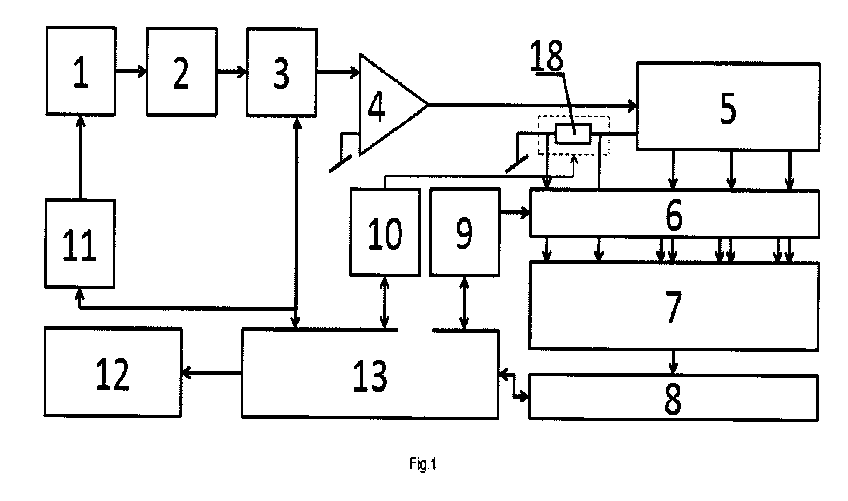

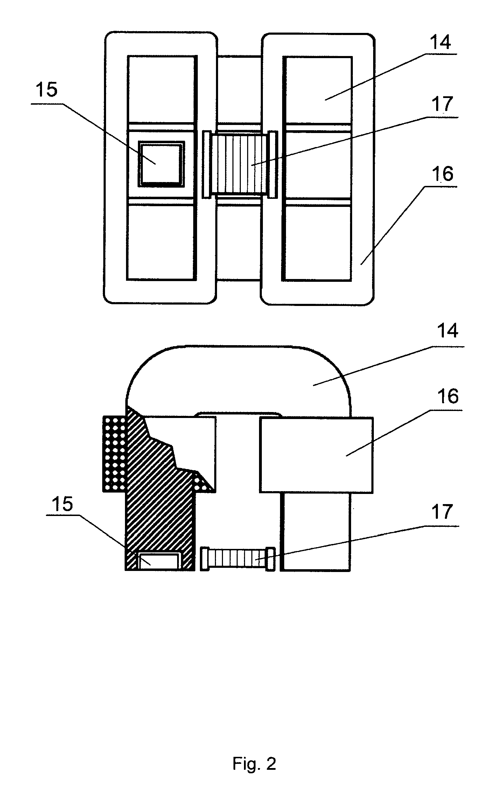

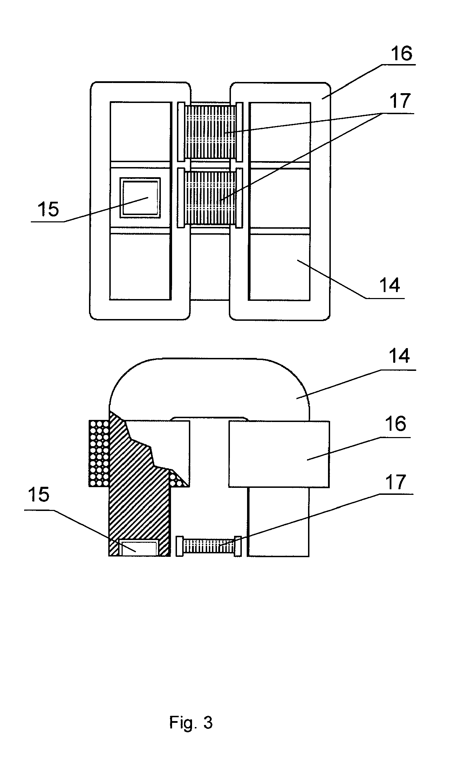

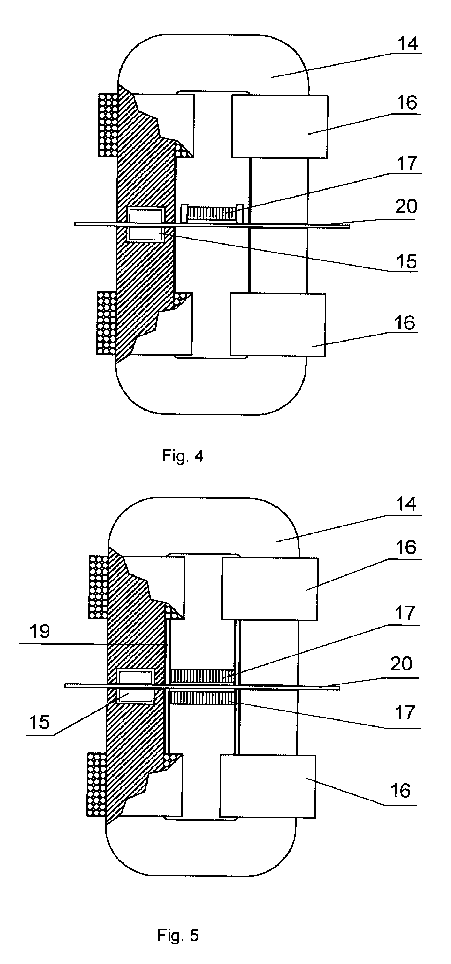

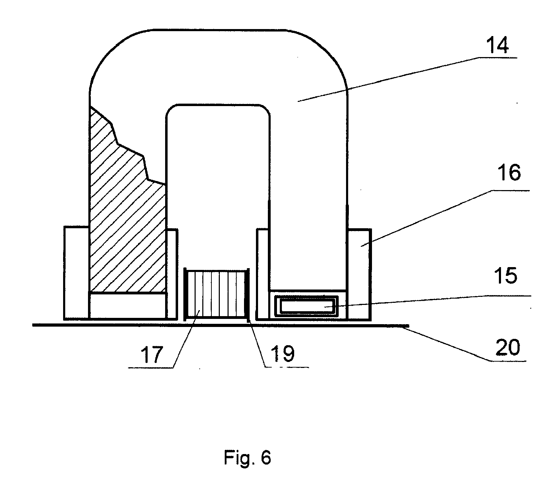

The subject of the invention, exemplified by the realizations presented in figures, shows the following: fig. 1 - the system for measuring characteristics of soft magnetic materials, in particular sheets and tapes, fig. 2 - the measuring head with one sensor for measuring magnetic field strength, in the bottom and front views, fig. 3 - the measuring head with two sensors for magnetic field strength, in the bottom and front views, fig. 4 - the measuring head with two excitation circuits, fig. 5 - the measuring head with two excitation circuits and vertical shields made of a soft magnetic material and fig. 6 the measuring head with magnetizing coils encompassing the inductive sensor.

### Example 1

The system for measuring characteristics of soft magnetic materials, especially sheets and tapes, contains a generator 1 connected through the block for signal conditioning 2, active filter 3 and power amplifier 4 with an input of measuring head 5, whose three couples of output terminals are connected through the circuit for measuring signals conditioning 6 with the circuit for data collection 7, whereas the circuit for data collection 7 is connected with an analog-digital transducer 8 connected to a microprocessor 13. The microprocessor 13 is also connected with a screen 12 and through the control circuit of the block for measuring signals conditioning 6, through the control system of the generator 11 with the generator 1 and also through the circuit for the shunt control 10, with the shunt 18 connected between the measuring head 5 and the ground. The terminals of the shunt 18 are connected with the circuit for conditioning measuring signals 6. The measuring head 5 has one excitation circuit made of three magnetizing yokes in a shape of U, arranged in relation to each other at a distance of less than 10.0 mm and creating three magnetic cores 14, on which one magnetizing coil 16 is positioned. At the pole of the middle magnetizing yoke, the inductive sensor 15 with a height of 3 mm is positioned, whereas between the poles of the yoke there is an inductive sensor of magnetic field strength 17.

### Example 2

The system for measuring characteristics of soft magnetic materials, especially sheets and bands, made as in Example 1 with the difference that the magnetizing yokes are arranged in relation to each other at a distance of 3.0 mm and in the pole of the middle magnetizing yoke there is an inductive sensor 15 made in the form of a coil for measuring magnetic flux, with a height less than 3 mm whereby the inductive sensor 15 is positioned inside the magnetizing yoke under the surface of its pole whereas between the poles of the middle and one of the external magnetizing yokes there are two inductive sensors of magnetic field strength 17.

### Example 3

The system for measuring characteristics of soft magnetic materials, especially sheets and tapes, made as in Example 1 with the difference that the measuring head 5 has two excitation circuits and each of them consists of at least one magnetizing yoke in a shape of U which makes a magnetic core 14, whereby one magnetic system 14 at the bottom and the second one on the top are directed toward each other with their magnetizing poles and their poles abut to each other; furthermore the windings of magnetizing coils 16 are connected in such manner that the magnetic flux of each pole couple of the bottom and the upper magnetic cores 14 are directed opposite to each other. Between the poles of the upper magnetizing yoke there is an inductive sensor of magnetic field strength 17, while in the pole of the upper magnetizing yoke there is an inductive sensor 15 and in the pole of the lower magnetizing pole there is an inductive sensor 15 and between the poles a tested object 20 in the form of a sheet is situated. Furthermore, on both magnetic cores 14, the lower and the upper, an additional magnetizing coil 16 is located, whereby the windings of the magnetizing coils 16 are connected in such way that magnetic fluxes of each pole couple of the upper and the lower magnetic core system 14 are directed opposite to each other, which at the short distance between the poles gives an uniform magnetic flux in the testing area of the measuring head 5.

### Example 4

The system for measuring characteristics of soft magnetic materials, especially sheets and tapes, made as in Example 3 with the difference that between the poles of the middle and one of the external magnetizing yoke there are two inductive sensors of magnetic field strength 17, which are magnetically coupled with vertical shields 19 made of a soft magnetic material.

### Example 5

The system for measuring characteristics of soft magnetic materials, especially sheets and tapes, made as in Example 1 with the difference that below the lower surface of the pole of magnetizing yoke there is an inductive sensor 15, positioned just above the surface of the tested object 20, in a form of a sheet. Furthermore, the inductive sensor of magnetic field strength 17 is magnetically coupled with vertical shields 19 made of a soft magnetic material.

### Example 6

The system for measuring characteristics of soft magnetic materials, especially sheets and tapes, made as in Example 5 with the difference that below the lower surface of both poles of the magnetizing yoke there is a inductive sensor 15, furthermore, the magnetizing coils 16 encompass the inductive sensor 15.

### Example 7

The system for measuring characteristics of soft magnetic materials, especially sheets and tapes, made as in Examples 5 and 6 with the difference that the measuring head 5 has an excitation circuit made of one magnetizing yoke in a shape of U, creating a magnetic core 14, on which two magnetizing coils 16 are located.

The size of the head is conditioned by the need of correct magnetization and the measurement of magnetic properties of the tested object 20. Small size of the measuring head 5 enables testing low-dimensional impressions and their inhomogeneities as well as inhomogeneity of the material itself, which makes possible to assess homogeneity of materials produced by various manufacturers. The system enables investigation of induction anisotropy and losses in magnetic cores composed of impressions from electrotechnical steel sheets as well as the source material itself.

### List of designations in the drawing:

1 - generator,
2 - block for signal conditioning,
3 - active filter,
4 - power amplifier,
5 - measuring head with induction- and magnetic field strength sensors
6 - circuit for measuring signals conditioning
7 - circuit for data collection S/H (sample/hold),
8 - analog-digital transducer,
9 - control circuit of the block for signal conditioning
10 - control system of the shunt,
11 - control system of the generator,
12 - screen,
13 - microprocessor,
14 - magnetic core,
15 - inductive sensor,
16 - magnetizing coil,
17 - inductive sensor of magnetic field strength,
18 - shunt,
19 - shield,
20 - tested object.

## Claims

1. A system for measuring characteristics of soft magnetic materials, especially sheets and tapes composed of a magnetizing winding and an analyzing circuit equipped with an amplifier and a filter, **characterized in that** it contains a generator (1) connected through a block for signal conditioning (2), active filter (3) and power amplifier (4) with an input of measuring head (5) whose at least one couple of output terminals is connected through the circuit for measuring signals conditioning (6) and the circuit for data collection (7) with an analog-digital transducer (8) connected to a microprocessor (13), whereas the microprocessor is connected with the screen (12) and through the control circuit of the block for measuring signals conditioning (9) with the circuit for conditioning measuring signals (6) through the control system for generator (11) with the generator (1) and also through the circuit for shunt control (10) with the shunt (18) connected between the measuring head (5) and the ground.

2. The system, as said by claim 1, **characterized in that** the terminals of the shunt (18) are connected with the circuit for measuring signals conditioning (6).

3. The system, as said by claim 1, **characterized in that** the measuring head (5) has at least one excitation circuit made of at least one magnetizing yoke in a shape of U, creating a magnetic core (14) on which at least one magnetizing coil (16) is located, whereby in a pole of the magnetizing yoke there is at least one inductive sensor (15) between the poles of the excitation circuit, there is at least one inductive sensor of magnetic field strength (17).

4. The system, as said by claim 3, **characterized in that** the excitation circuit is made of three identical magnetizing yokes in a shape of U, arranged in relation to each other at a distance of less than 10.0 mm.

5. The system, as said by claim 3, **characterized in that** the inductive sensor (15) is made in the form of a coil for measuring magnetic flux, with a height less than 5 mm.

6. The system, as said by claim 3, **characterized in that** the inductive sensor (15) is positioned inside a magnetizing yoke under the surface of its pole.

7. The system, as said by claim 3, **characterized in that** the measuring head (5) has two excitation circuits and each of them consists of at least one magnetizing yoke in a shape of U which makes a magnetic core (14), whereby the magnetic system at the bottom and the magnetic system on the top are directed toward each other with their magnetizing poles which stick to each other.

8. The system, as said by claim 7, **characterized in that** the windings of magnetizing coils (16) are connected in such manner that the magnetic flux of each pole couple of the bottom and the upper magnetic cores (14) are directed opposite to each other.

9. The system, as said by claim 3, **characterized in that** the inductive sensor of magnetic field strength (17) is magnetically coupled with the vertical shields (19) made of soft magnetic material.

10. The system, as said by claim 3, **characterized in that** below the lower surface of at least one pole of the magnetizing yoke there is an inductive sensor (15), and advantageously, the magnetizing coils (16) encompass the inductive sensor (15), furthermore, the inductive sensor of magnetic field (17) is magnetically coupled with vertical shields (19) made of a soft magnetic material.
